## Europäisches Patentamt

## European Patent Office

## Office européen des brevets

(19)

(11) Publication number:　**0 248 904**

A1

# EUROPEAN PATENT APPLICATION

published in accordance with Art. 158(3) EPC

(12)

(21) Application number: 85906082.4

(22) Date of filing: 27.11.85

Data of the international application taken as a basis:

(86) International application number: 
PCT/JP85/00656

(87) International publication number:
WO87/03235 (04.06.87 87/12)

(51) Int. Cl.³: **B 23 P 19/00**
**H 05 K 13/00**

(43) Date of publication of application:
16.12.87 Bulletin 87/51

(84) Designated Contracting States:
DE

(71) Applicant: Matsushita Electric Industrial Co., Ltd.
1006, Oaza Kadoma
Kadoma-shi Osaka-fu, 571(JP)

(72) Inventor: MARUYAMA, Masahiro
14-39, Hanjyo 2-chome
Minoo-shi Osaka-fu 562(JP)

(72) Inventor: HATA, Kanji
6-8, Yamate 5-chome
Kisaichi, Katano-shi Osaka-fu 576(JP)

(72) Inventor: ITEMADANI, Eiji
394-1, Minamihanada-cho
Sakai-shi Osaka-fu 591(JP)

(72) Inventor: UCHIDA, Yoshihisa
652-25, Oaza Takanomiya
Neyagawa-shi Osaka-fu 572(JP)

(74) Representative: Dr. Elisabeth Jung Dr. Jürgen
Schirdewahn Dipl.-Ing. Claus Gernhardt
P.O. Box 40 14 68 Clemensstrasse 30
D-8000 München 40(DE)

(54) **METHOD OF CARRYING OUT OPERATION IN WORKING APPARATUS.**

(57) Method of carrying out an operation in a working apparatus, such as an automatic electronic part-mounting apparatus, and more particularly to a method of carrying out an operation in a working apparatus which is provided with a carrier (6) for retaining a work (1) on a working line (5), transferring the same to a subsequent state, and a working head (2) for giving a predetermined treatment to a predetermined treatment to a predetermined portion of the work (1) which is transferred to a work area (3) on the working line (5) by the carrier (6). The characteristics of the method according to the present invention reside in that, in the above working apparatus, the work (1) is transferred in the X-direction as the working points in the X-direction are determined in the work area (3) with the working head (2) transferred in the X-Y direction as the working points on the X-Y coordinates are determined, the working point in the X-direction in the working head (2) in a subsequent operation being determined by correcting the same by the correction data consisting of an amount of movement ΔX of the work (1) in the X-direction, which is measured in each operation. The characteristics of the pre-sent invention also reside in that, owing to the above construction, the loading time required for discharging the treated work (1) from the work area (3) and introducing a subsequent untreated work (1) into a position in which a treatment therefor can be done can be reduced to a great extent, whereby the working efficiency can be improved.

FIG.5

EP 0 248 904 A1

DESCRIPTION

TITLE OF THE INVENTION

Working method for a working apparatus

TECHNICAL FIELD

The present invention relates to a working method for a working apparatus comprising a carrier for holding works on a working line and transporting them and a work head which applies a predetermined operation on a predetermined position at the work transported by the carrier to a work area on the working line.

Especially, the method of the present invention is suitable to be applied to a working apparatus for automatically mounting electronic parts, such as chip type resistance, chip type laminated capacitor, etc., onto a substrate constituting an electronic circuit.

The present invention purports to provide a working method which can largely reduce a loading time of charging the work into the work area and discharging the same therefrom.

Especially the present invention purports to provide a working method enabling the work efficiency to be remarkably improved at operation of less number of times per one work.

BACKGROUND ART

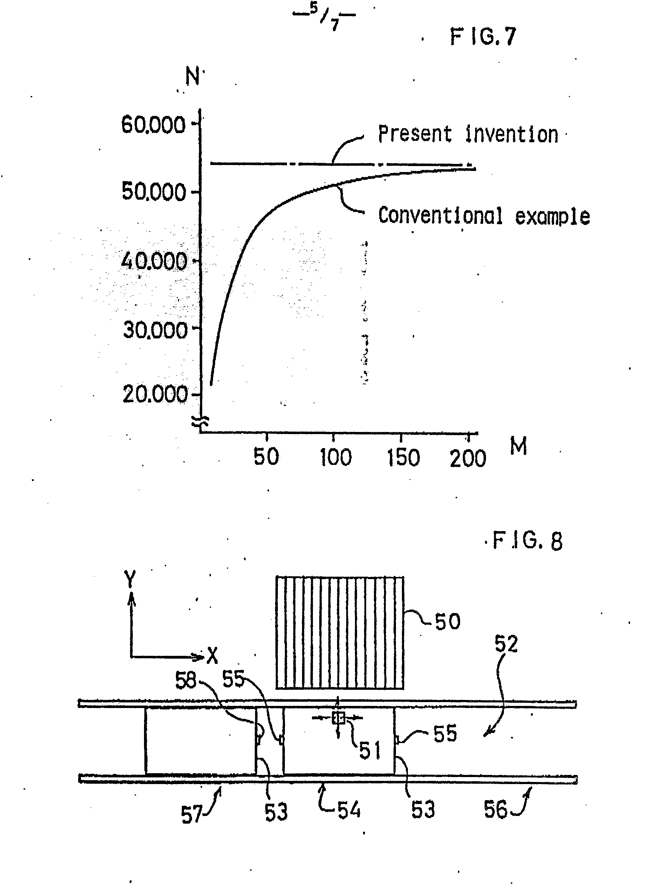

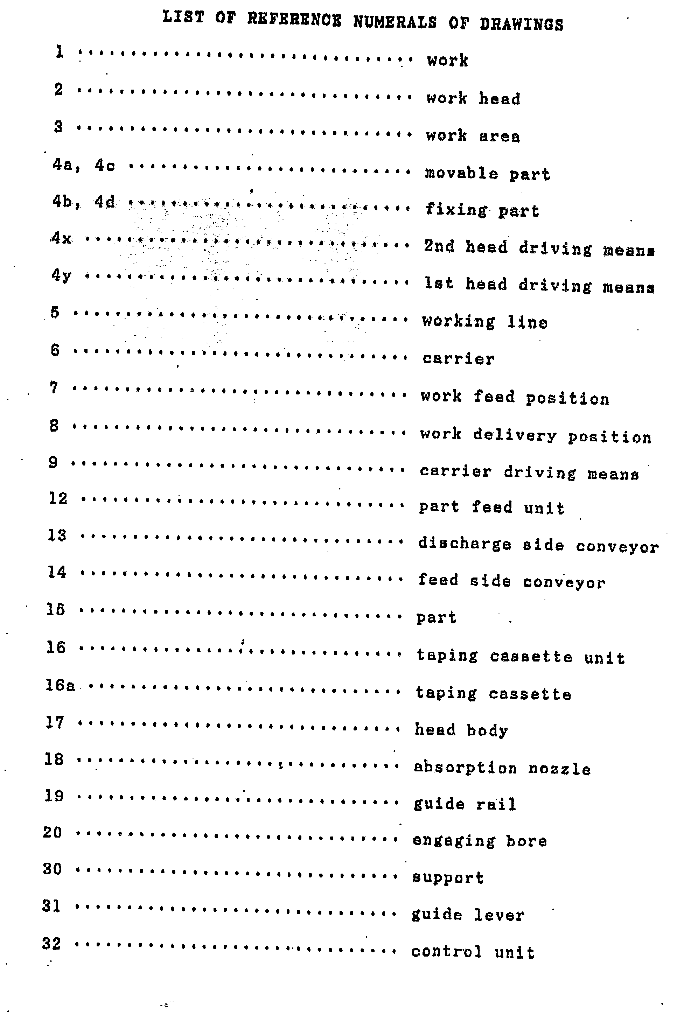

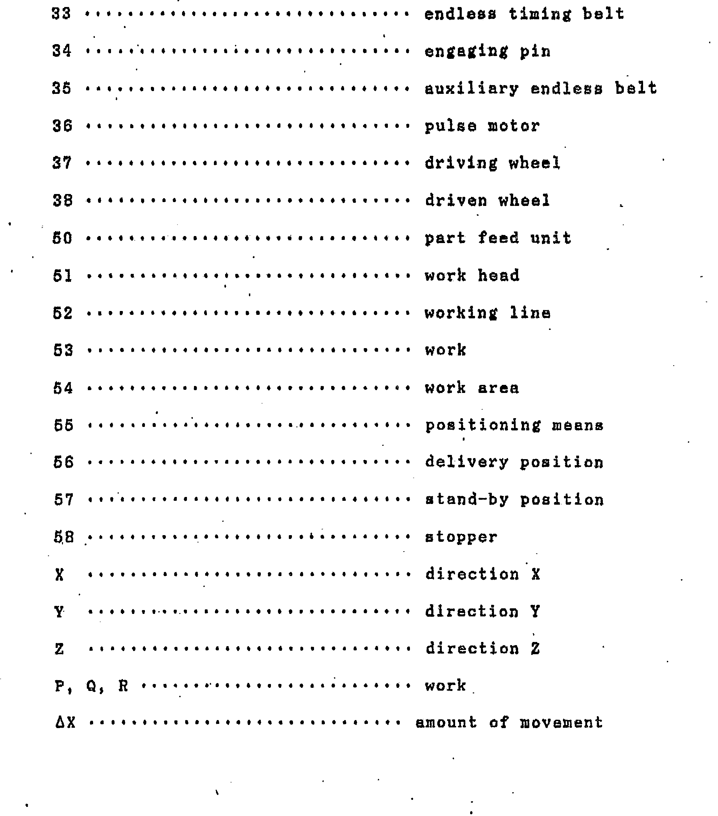

As the conventional work apparatus of this kind there is one as shown in FIG. 8.

1

The conventional apparatus relates to an automatic part-mounting apparatus which picks up by a work head 51 an electronic part disposed on a part feed unit 50 and transports the part to the work, concretely to say, a substrate 53 on a working line 52, thereby mounting the electronic part at a predetermined position on the substrate 53. The work head 51 moves in two horizontal directions, that is, the directions X and Y, to decide a point of operation through which the electronic part is mounted on the substrate 53.

On the other hand, the substrate 53 is adapted to be positioned by a positioning means 55 on a predetermined position in a work area 54 on the working line 52, thereby being subjected to the mounting operation. The substrate 53 on which a necessary number of electronic parts are mounted is transported to a delivery position 56. About that time, the next substrate standing-by at a stand-by position 57 is charged in the work area 54 and the electronic parts are mounted similarly to the above on the next substrate 53. In addition, reference numeral 58 designates a stopper for keeping the substrate 53 at the stand-by position 57.

The working method for the conventional apparatus takes a relatively long loading time of several seconds to about 5 seconds to discharge the substrate 53 finished of its mounting operation from the work area 54

2

and charge the next substrate into the work area 54.

When the number of part mounting points per one substrate is small, a loss in the loading time largely affects the work efficiency, which becomes main cause of deterioration in the work efficiency.

In a graph shown in FIG. 7, the number of part mounting positions per one substrate is taken on the axis M of abscissa and that of the entire part mounting positions for 400 minutes is taken on the axis N of ordinate, and a curve of work efficiency at the conventional example is shown by the solid line, and from this graph the above matter will apparently be seen.

DISCLOSURE OF INVENTION

The present invention is to propose, to solve the problem in working process, a working method for a working apparatus comprising a carrier for holding works on a working line and discharging them and a work head for applying a predetermined operation on a predetermined position at the work transported by the carrier in the work area on the working line, wherein the working method is characterized in that the works are moved in the direction X at the work area while deciding a point of operation in the direction X, a work head 2 are moved while deciding a point of operation on the coordinate X-Y in the directions X and Y, and an amount of movement $\Delta X$ of the work moving in the direction X per one operation is

3

used correction data, so that a point of operation of the work head in the direction X during the next operation is corrected by the amount of movement ΔX and decide.

As what is more concretely constituted of the present invention, there is one which adopts a method that works are continuously fed on the working line and moved sequentially toward a work feed position, the work area and a work delivery position, moving each work synchronously in the direction X, and the above-mentioned synchronous movement is set to become a motion to decide the point of operation in the direction X with respect to the work positioned in the work area.

As what is further concretely constituted of the present invention in other mode, there is one which adopts a method that plural works are disposed movable independently of each other in the direction X on the working line, and when the entire operations are finished with respect to the works positioned in the work area the work is transported out of the work area, and simultaneously the next work standing-by on the working line is transported into the work area.

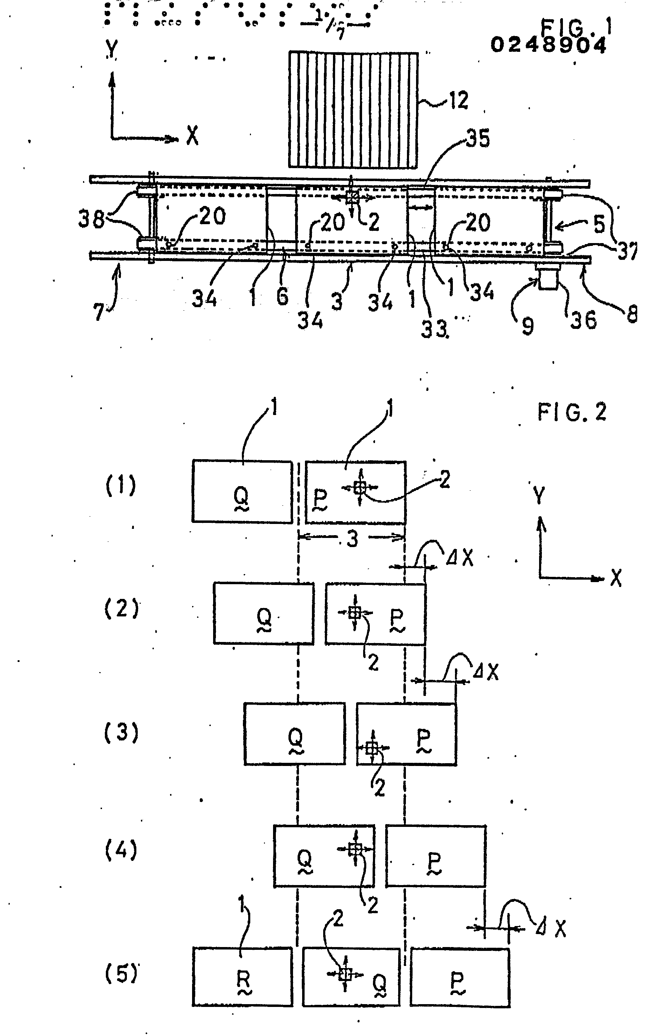

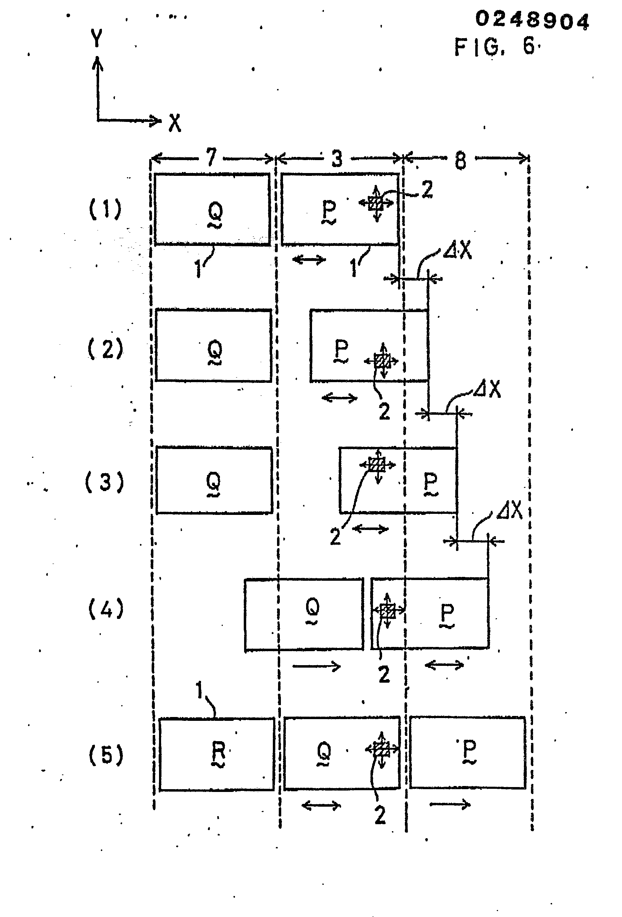

The present invention being constructed as the above-mentioned, as shown in FIGs. 2 and 6, when the work 1 completed of its operation in the work area 3 is discharged, the next work 1 can be transported into the work area 3, so as to be stand-by to the next operation.

4

Thus, according to the present invention transfer to the next work can be made upon finishing operation of one work 1 at the work area 3, almost without the need of a loading time in continuation thereto. Accordingly, as shown by the phantom line in the graph of FIG. 7, ideally the work efficiency can be made in the best condition regardless of the number of operations per one work 1.

BRIEF DESCRIPTION OF DRAWINGS

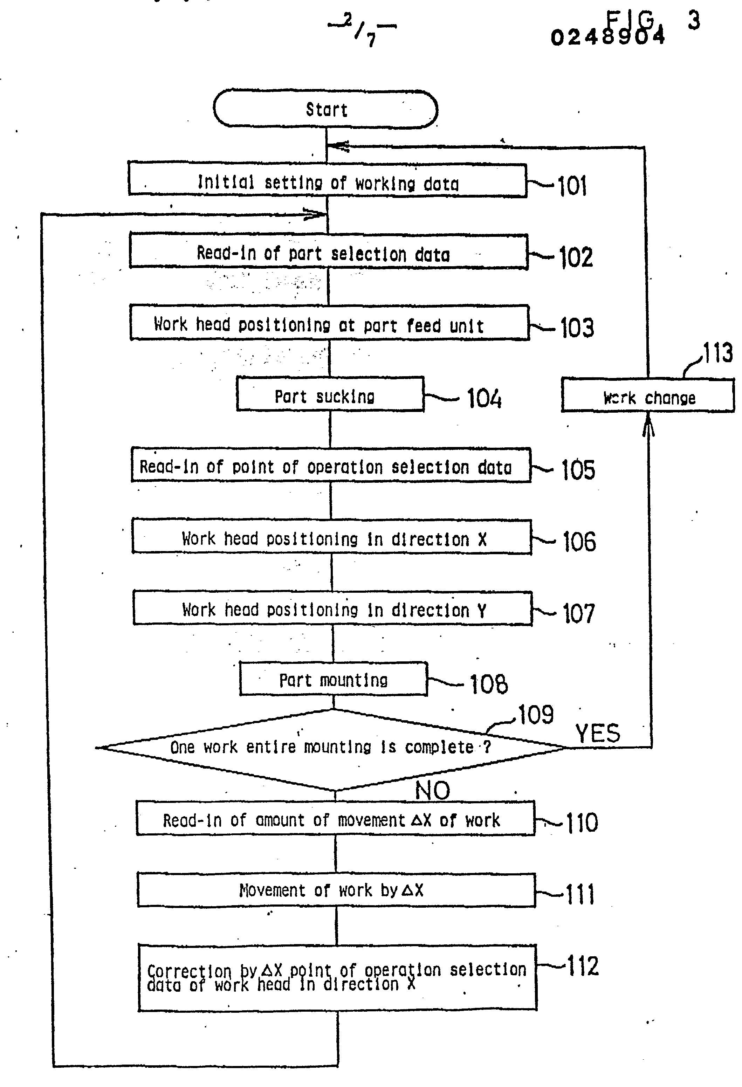

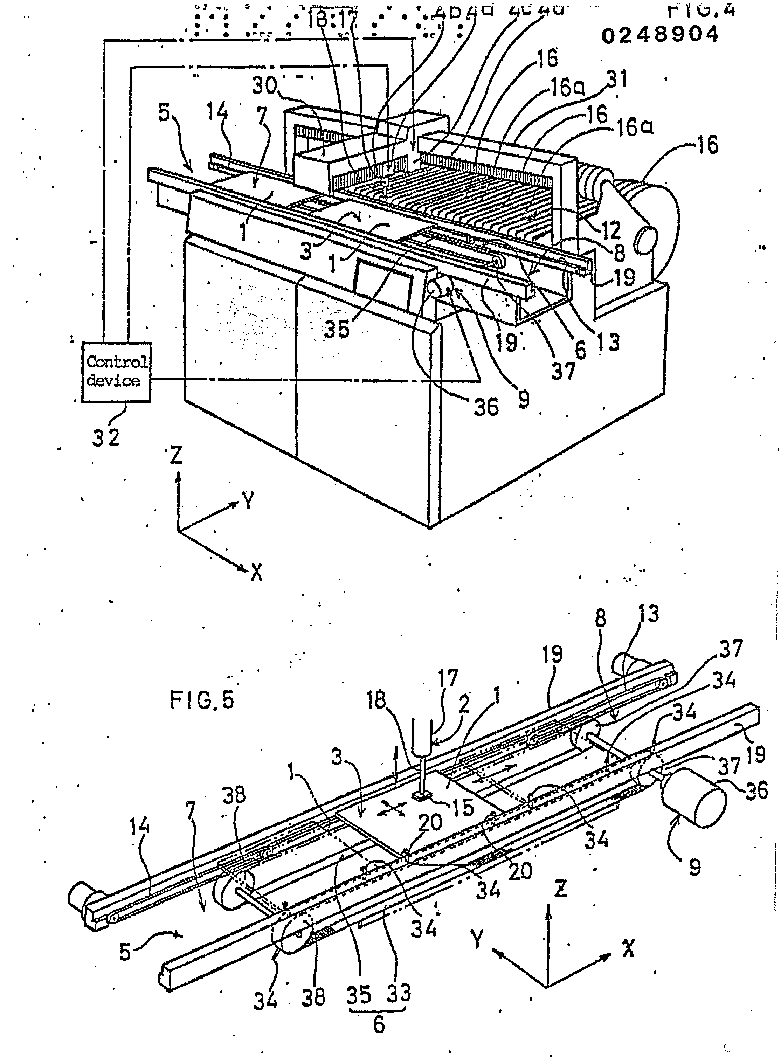

FIG. 1 is a plan view of a first embodiment of a working method of the invention, showing the principle thereof, FIG. 2 is a plan view showing the operation of the first embodiment in principle, FIG. 3 is a flow chart thereof, FIG. 4 is a perspective view of the entire first embodiment of the invention, FIG. 5 is a perspective view showing a carrier and carrier driving means, FIG. 6 is a plan view of a second embodiment of the working method of the invention, showing operation thereof in principle, FIG. 7 is a graph comparing the work efficiencies of the present invention and of the conventional example, and FIG. 8 is a plan view principally showing the conventional example.

BEST MODE FOR CARRYING OUT THE INVENTION

A first embodiment of a working method of the invention is shown in FIGs. 1 through 5. The embodiment relates to an electronic part mounting apparatus which

5

automatically mounts a large number of electronic parts
(to be hereinafter called the parts) 15 (refer to FIG. 5)
sequentially at predetermined positions on a substrate 1
(to be hereinafter called the work).

In a part feed unit 12 of the electronic part
mounting apparatus applied with the present invention are
disposed a large number of taping cassettes 16a in
parallel, each taping cassette 16a including therein many
parts 15 in alignment.. The taping cassettes 16a are
intermittently transported in the direction Y, and one of
parts 15 coming to the pick up position is selectively
picked-up by the work head 2 in every one mounting opera-
tion.  The parts at the pick up positions on each taping
cassette 16a are almost aligned.

The work head 2 functions to pick up the part 15
from the part feed unit 12, transport the same to the work
area 3 on the working line 5, and mount the same on the
predetermined position on the work 1.  And the work head 2
comprises, as shown in FIG. 4, a head body 17 and a
suction nozzle 18 moving vertically thereto, that is, the
direction Z, with respect to the head body 17.  The
suction nozzle 18 has a function to suck up the part 15
from the taping cassette 16a and pick up the same by using
vacuum pressure.

The above-mentioned work head 2 is constructed
to be movable in the directions X and Y.  A first head

driving means 4y, which controls the moving position of the work head 2 while moving in the direction Y, consists of a linear pulse motor comprising a movable part 4a provided integral with the head body 17 and a fixing part 4b formed at a support 30. And the first head driving means 4y controls the moving position and speed of the work head 2 in the direction Y on the basis of a pulse signal from a control unit 32. The support 30 moves along a guide lever 31 disposed in the direction X, and a second head driving means 4x, which controls the moving position of the support 30 while moving in the direction X, consists of a linear pulse motor comprising a movable part 4c provided integral with the support 30 and a fixing part 4d formed at the guide lever 31. And also the second head driving means 4x controls the moving position and speed of the support 30, hence the work head 2, in the direction X, basing on the signal from the above-mentioned control unit 32.

In addition, moving of the suction nozzle 18 in the direction Z is made by driving means, such as an air cylinder (not shown), and the moving in the direction Z can be made also controlled by the control unit 32.

On the working line 5 extending in the direction X, as shown in FIG. 5, are disposed a pair of guide rails 19 for supporting and guiding the work 1, a feed side conveyor 14 for feeding the work 1, and a discharge side

7

conveyor 13 for discharging the work 1 completed of the part mounting operation at the work area 3. Also, a carrier 6 for holding the work 1 and transporting it is disposed on the working line 5.

The carrier 6 comprises an endless timing belt 33 provided with a number of engaging pins and an auxiliary endless belt 35 disposed in parallel to the belt 33.

The carrier 6 is driven by a carrier driving means comprising a pulse motor 36, driving wheels 37, 37 connected thereto, and driven wheels 38, 38. The carrier driving means 9 moves the carrier 6 in the direction X, positions it in the direction X, and controls the moving speed thereof on the basis of the pulse signal from the control unit 32.

The carrier 6 holds the work 1 by engaging the engaging pins 34 on the endless timing belt 33 with engaging bores 20 formed at the work 1, and functions to transport the work 1 in the direction X. By the engagement of the engaging pins 34 with the engaging bores 20 at the work 1 on the feed side conveyor 14 at the work feed position 7 on the working line 5, the work 1 can be transferred from the feed side conveyor 14 to the carrier 6. On the other hand, at the work delivery position 8 on the working line 5, by making the engaging pins 34 disengage from the engaging bores 20, the work 1 can be transferred

8

from the carrier 6 to the discharge side conveyor 13.

Next, one embodiment of a working method of the present invention in the apparatus constructed as the above-mentioned will be described.

The above-mentioned control unit 32 is constituted to carry out the method of the present invention by controlling, in compliance with the predetermined program, the carrier driving means 9, a first driving means 4y, a second driving means 4x, driving means for vertically moving the suction nozzle 18, and driving means for applying vacuum pressure to the suction nozzle 18.

FIG. 2 principally shows movement of work 1 and work head 2 in the method of the invention, and FIG. 3 shows a control flow chart.

In FIG. 2-(1), the work 1 designated by P is in the work area 3 and subjected to the part mounting operation by the work head 2. Upon finishing one mounting operation, the work P moves by $\Delta X$ as shown in FIG. 2-(2). At that time, an amount of movement $\Delta X$ serves as correction data when the point of the next operation of the work head 2 in the direction X is decided.

In FIG. 2-(2), the next mounting operation is applied to the work P, at which time the point of operation of the work head 2 in the direction X is corrected to shift the reference position by the amount of movement $\Delta X$, and decided. After such operation finishes, the work P

9

moves by ΔX as shown in FIG. 2-(3). Thus, the point of operation in the next mounting operation of the work head 2 in the direction X is corrected by an amount of movement ΔX similarly as the above, and decided.

Thus, while the work P is being subjected to the mounting operation, the work 1 designated by Q moves in association with the work P in the direction X to enter in the work area 3 as shown in FIGs. 2-(2) and -(3). When the mounting operation in the direction Y is over as shown in FIG. 2-(4), the next mounting operation is carried out with respect to the work Q. For the work Q, the point of operation of work head 2 in the direction X is decided also by using the amount of movement ΔX in the direction X in every operation as the correction data.

While the mounting operation is being carried out with respect to the work Q, a work 1 designated by R as shown in FIG. 2-(5), moves in association with the works P and Q to approach the work area 3 and thereafter enters therein.

The works P, Q and R thus fed continuously to the working line 5 are subjected sequentially to the mounting operation by the work head 2. In the present invention, when one work 1 is finished of its entire operation in the work area 3, a predetermined operation can be applied to the next work 1 standing-by therein, without a loss in the loading time. The point of

10

operation in the direction X among those on the coordinate X-Y of the work head 2 with respect to the work 1 is decided in consideration of the amount of movement $\Delta X$ (although $\Delta X$ is not constant in FIG. 2, in this case $\Delta X=0$ may be included and $\Delta X$ can be made constant), and thereby the work 1 can move in order in one direction of X, while being subjected to the predetermined operation.

A control flow chart shown in FIG. 3 is exemplary of a program for executing the aforesaid working method. In step 101, operation data is initially set for sequence-controlling of the carrier driving means 9, first head driving means 4y, second head driving means 4x, driving means for vertically moving the absorption nozzle 18, and driving means for applying vacuum pressure to the absorption nozzle 18. Next, in step 102, part selection data is read in; and in step 103, the work head 2 at the part feed unit 12 is positioned on the coordinates X-Y on the basis of the step 102. Next, in step 104, the suction nozzle 18 is lowered and subjected to vacuum pressure, to thereby sucks the part 15 to the work head 2, and thereafter the absorption nozzle 18 is lifted.

In step 105, the point of operation selecting data, in other words, data of point of operation in the direction X and data of point of operation in the direction Y of the work head 2, are read in. In step 106, on the basis of the above, the work head 2 is moved toward

11

the point of operation in the direction X and positioned, and in step 107, the work head 2 is moved to the point of operation in the direction Y and positioned. Next, in step 108, the next series of operations (part mounting operations) are carried out. That is, after the suction nozzle 18 is lowered to mount the part 15 at the predetermined position on the work 1, the vacuum pressure is released to lift the suction nozzle 18, and then the work head 2 is restored to the reference position of the part feed unit 12.

In step 109, it is decided whether or not the entire mounting operation for one work 1 is completed. When it is YES in step 113, the carrier 6 is moved by a predetermined amount in the direction X to carry out work change so that the next work 1 instead of the operation completed work can be subject to the operation, and thereafter the operation is returned to the step 101. On the other hand, when it is NO in the step 110, the amount of movement $\Delta X$ data (inclusive of $\Delta X=0$) of the work 1 in the direction X is read in, and basing thereon in the step 111, the work 1 is moved by $\Delta X$ in the direction X. Next, in step 112, after amending the data of selecting the point of operation of the work head 2 in the direction X on the basis of the $\Delta X$, the operation is returned to the step 102.

In the first embodiment, the works 1 are sequen-

12.

tially fed on the working line 5 and each work 1 is constituted to move in synchronism with each other in the direction X; but, as in the second embodiment shown in FIG. 6, it is possible to constitute that plural carriers 6 movable independently from each other in the direction X are disposed on the working line 5, thereby to hold the works 1, and further, simultaneously with transferring-out of the operation-finished work 1 by the carrier 6, the next work 1 is transported by the carrier 6 holding the same onto the point of operation.

Referring to FIGs. 6-(1) through -(3), the work Q stands by at the workfeed position while the work P is being subjected to a predetermined operation by the work head 2 at the work area. Immediately before finishing of the operation of work P, the work Q as shown in FIG. 6-(4), moves into the work area 3. Next, when the work P is finished of its operation and is transported to the work delivery position 8, the work Q, as shown in FIG. 6-(5), reaches the point of operation so as to be subjected to the predetermined operation by the work head 2. At that time the next work R stands by at the work feed position 7. In addition, similarly to the first embodiment, in this second embodiment also, the amount of movement ΔX of moving work 1 in the direction X per one operation is used as the correction data in correcting and deciding the point of operation in the direction X of the work head 2

13

of the next operation, by the amount of movement ΔX.

The present invention may be variously constructed other than the aforesaid embodiments. For
example, although in the above-mentioned embodiment shows
an example wherein directions X and Y are perpendicular to
each other they are not limited therein. Also, the
present invention is applicable to a working method for a
working apparatus, such as a soldering apparatus or a
boring apparatus.

INDUSTRIAL APPLICABILITY

As is obvious from the above elucidation, in
compliance with the conventional example, the present
invention can largely reduce the loading time necessary to
transport the work finished of operation from the working
area and transport the next work into the operable
position, resulting in that an improvement in work
efficiency is obtainable. Especially, in case the number
of point of operation per one work is small, the
improvement of work efficiency will be remarkable.

14

## CLAIMS

1.      In a working method in a working apparatus
comprising a carrier for holding work$ on a working line
and transporting said works and work head for applying
predetermined operations at predetermined positions on
said works transported by said carrier into a work area on
said work line, said working method being characterized in
that

said works are moved in the direction X at said
work area while deciding the point of operation in said
direction, said work head are moved in the directions X
and Y while deciding the point of operation on the
coordinate X-Y, and an amount of movement $\Delta X$ of said work
in the direction X per one operation is used as correction
data, so that the point of operation of said work head in
the direction X during the next operation is amended by
said amount of movement $\Delta X$ and decided.

2.      In a working method in a working apparatus
comprising a carrier for holding works on a working line
and transporting said works and a work head for applying
predetermined operations at predetermined positions on
said works transported by said carrier into said work area
on said work line, said working method being characterized
in that

said works are fed consecutively onto said
working line, each of said works is moved sequentially toward a work feed position, said work area, and a work delivery position, while moving in synchronism in the direction X, said synchronized movement is set to become movement to decide the point of operation in the direction X with respect to said work positioned in the work area, said work head are moved in the directions X and Y while deciding the point of operation on the coordinate X-Y, and an amount of movement $\Delta X$ of said work in the direction X per one operation is used as correction data, so that the point of operation of said work head in the direction X during the operation is corrected by said amount of movement $\Delta X$ and decided.

3.      In a working method in a working apparatus comprising a carrier for holding works on a working line and transporting said works and a work head for applying predetermined operations at predetermined positions on said works transported into said work area on said work line, said working method being characterized in that

plural works moving independently from each other in the direction X on said working line are disposed, said works positioned in said work area are moved in the direction X while deciding the point of operation in said direction, said work heads are moved in the directions X and Y while deciding the point of operation on the coordinate X-Y, an amount of movement $\Delta X$ of said work moving in the direction X per one operation is used as correction data so that the point of operation of said work head in the direction X during the next operation is amended by said amount of movement ΔX and decided for operation, and at the point of time when the entire operations with respect to said work positioned in said work area, said work standing-by on said working line is transported into said work area simultaneously with transportation of said work out of said work area.

FIG. 1
0248904

FIG. 2

```
                    ┌──────────────────┐
                    │      Start       │
                    └──────────────────┘
                             │
        ┌────────────────────────────────────────┐
        │    Initial setting of working data     │──101
        └────────────────────────────────────────┘
                             │
        ┌────────────────────────────────────────┐
        │       Read-in of part selection data   │──102
        └────────────────────────────────────────┘
                             │
        ┌────────────────────────────────────────┐
        │  Work head positioning at part feed unit│──103
        └────────────────────────────────────────┘
                             │                            ┌──113
            ┌──────────────────────────┐         ┌──────────────────┐
            │       Part sucking       │──104    │   Work change    │
            └──────────────────────────┘         └──────────────────┘
                             │
        ┌────────────────────────────────────────┐
        │  Read-in of point of operation selection data│──105
        └────────────────────────────────────────┘
                             │
        ┌────────────────────────────────────────┐
        │   Work head positioning in direction X │──106
        └────────────────────────────────────────┘
                             │
        ┌────────────────────────────────────────┐
        │   Work head positioning in direction Y │──107
        └────────────────────────────────────────┘
                             │
            ┌──────────────────────────┐
            │      Part mounting       │──108
            └──────────────────────────┘
                             │                    ──109
              ◇ One work entire mounting is complete ? ◇────YES
                             │NO
        ┌────────────────────────────────────────┐
        │  Read-in of amount of movement ΔX of work│──110
        └────────────────────────────────────────┘
                             │
        ┌────────────────────────────────────────┐
        │        Movement of work by ΔX          │──111
        └────────────────────────────────────────┘
                             │
        ┌────────────────────────────────────────┐
        │ Correction by ΔX point of operation selection│──112
        │   data of work head in direction X     │
        └────────────────────────────────────────┘
```

FIG.4

0248904

FIG.5

FIG.7

FIG. 8

## LIST OF REFERENCE NUMERALS OF DRAWINGS

| | |
|---|---|
| 1 | work |
| 2 | work head |
| 3 | work area |
| 4a, 4c | movable part |
| 4b, 4d | fixing part |
| 4x | 2nd head driving means |
| 4y | 1st head driving means |
| 5 | working line |
| 6 | carrier |
| 7 | work feed position |
| 8 | work delivery position |
| 9 | carrier driving means |
| 12 | part feed unit |
| 13 | discharge side conveyor |
| 14 | feed side conveyor |
| 15 | part |
| 16 | taping cassette unit |
| 16a | taping cassette |
| 17 | head body |
| 18 | absorption nozzle |
| 19 | guide rail |
| 20 | engaging bore |
| 30 | support |
| 31 | guide lever |
| 32 | control unit |

33 ···································· endless timing belt

34 ···································· engaging pin

35 ···································· auxiliary endless belt

36 ···································· pulse motor

37 ···································· driving wheel

38 ···································· driven wheel

50 ···································· part feed unit

51 ···································· work head

52 ···································· working line

53 ···································· work

54 ···································· work area

55 ···································· positioning means

56 ···································· delivery position

57 ···································· stand-by position

58 ···································· stopper

X  ···································· direction X

Y  ···································· direction Y

Z  ···································· direction Z

P, Q, R ····························· work

ΔX ···································· amount of movement

0248904

# INTERNATIONAL SEARCH REPORT

International Application No. PCT/JP85/00656

## I. CLASSIFICATION OF SUBJECT MATTER (if several classification symbols apply, indicate all) [3]

According to International Patent Classification (IPC) or to both National Classification and IPC

Int.Cl[4]  B23P 19/00 · H05K 13/00

## II. FIELDS SEARCHED

| Minimum Documentation Searched [4] | |
|---|---|
| Classification System | Classification Symbols |
| IPC | B23P 19/00-21/00   B23Q39/04   H05K 13/00-13/04 |

| Documentation Searched other than Minimum Documentation to the Extent that such Documents are Included in the Fields Searched [5] |
|---|
| Jitsuyo Shinan Koho           1926 – 1985   Jitsuyo Shinan Kokai Koho     1971 – 1985 |

## III. DOCUMENTS CONSIDERED TO BE RELEVANT [14]

| Category[*] | Citation of Document, [16] with indication, where appropriate, of the relevant passages [17] | Relevant to Claim No. [18] |
|---|---|---|
| Y | JP, B2, 57-036101 (Matsushita Electric Industrial Co., Ltd.), 2 August 1982 (02. 08. 82) & US, A, 4,166,316 & CA, A1, 1,076,332 | 1 - 3 |
| Y | JP, A, 60-080532 (Sanyo Kiko Kabushiki Kaisha), 5 August 1985 (05. 08. 85) (Family: none) | 1 - 3 |

* Special categories of cited documents: [15]
"A" document defining the general state of the art which is not considered to be of particular relevance
"E" earlier document but published on or after the international filing date
"L" document which may throw doubts on priority claim(s) or which is cited to establish the publication date of another citation or other special reason (as specified)
"O" document referring to an oral disclosure. use. exhibition or other means
"P" document published prior to the international filing date but later than the priority date claimed

"T" later document published after the international filing date or priority date and not in conflict with the application but cited to understand the principle or theory underlying the invention
"X" document of particular relevance: the claimed invention cannot be considered novel or cannot be considered to involve an inventive step
"Y" document of particular relevance; the claimed invention cannot be considered to involve an inventive step when the document is combined with one or more other such documents, such combination being obvious to a person skilled in the art
"&" document member of the same patent family

## IV. CERTIFICATION

| Date of the Actual Completion of the International Search [2] | Date of Mailing of this International Search Report [2] |
|---|---|
| December 25, 1985 (25. 12. 85) | January 13, 1986 (13. 01. 86) |
| International Searching Authority [1] | Signature of Authorized Officer [20] |
| Japanese Patent Office | |

Form PCT/ISA/210 (second sheet) (October 1981)